# EUROPEAN PATENT APPLICATION

(11) **EP 4 618 711 A1**
(43) Date of publication of application: **17.09.2025**
(21) Application number: 24207137.1
(22) Date of filing: 17.10.2024
(51) Int. Cl.: H10B 12/00

(54) **SEMICONDUCTOR DEVICE**

(30) Priority: 15.03.2024 KR 20240036283
(71) Applicant: Samsung Electronics Co., Ltd, Suwon-si, Gyeonggi-do 16677 (KR)
(72) Inventor: CHOI, Deokhwan, 16677 Suwon-si, Gyeonggi-do (KR); KIM, Hyeontae, 16677 Suwon-si, Gyeonggi-do (KR); SONG, Jaejoon, 16677 Suwon-si, Gyeonggi-do (KR); HAN, Chanhee, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate including a first region and a second region spaced apart from the first region, a cell stack structure on the first region, and a peripheral gate structure on the second region. The cell stack structure includes channel patterns at least partially overlapping each other in a vertical direction perpendicular to an upper surface of the substrate, a bit line electrically connected to at least one of the channel patterns and extending in a first direction parallel to the upper surface of the substrate, and a word line extending in a second direction parallel to the upper surface of the substrate and intersecting the first direction.

## Description

### CROSS-REFERENCE TO RELATED APPLICATIONS

This U.S. non-provisional patent application claims priority under 35 U.S.C. § 119 of Korean Patent Application No. 10-2024-0036283, filed on March 15, 2024, the entire contents of which are hereby incorporated by reference.

### BACKGROUND

The present disclosure herein relates generally to a semiconductor device, and more particularly, to a semiconductor device including a peripheral gate structure.

In the electronic industry, semiconductor devices are regarded as important elements due to characteristics such as a small size, multiple functions, and/or a low manufacturing cost. Semiconductor devices may be classified into semiconductor memory devices for storing logical data, semiconductor logic devices for processing operations on logical data, and hybrid semiconductor devices including a memory element and a logic element.

Recently, with an increase in operational speed and reduction in power consumption of electronic devices, semiconductor devices included in such electronic devices are required to have a high operational speed and/or low operational voltage. To satisfy such requirements, more highly integrated semiconductor devices are necessary. However, as semiconductor devices are more highly integrated, electrical characteristics and production yield of the semiconductor devices may deteriorate. Therefore, researches are being carried out actively to improve the electrical characteristics and production yield of semiconductor devices.

### SUMMARY

The present disclosure provides a semiconductor device with improved electrical characteristics and integration density.

An embodiment of the inventive concept provides a semiconductor device including: a substrate including a first region and a second region spaced apart from the first region; a cell stack structure that is in contact with the first region; and a peripheral gate structure that is in contact with the second region, wherein the cell stack structure includes: channel patterns overlapping each other; a bit line electrically connected to at least one of the channel patterns and extending in a first direction; and a word line extending in a second direction intersecting the first direction.

In an embodiment of the inventive concept, a semiconductor device includes: a substrate including a first region and a second region spaced apart from the first region; a cell stack structure on the first region; a dummy stack structure on the second region; a semiconductor structure on the cell stack structure and the dummy stack structure; and a peripheral gate structure on the semiconductor structure, wherein the cell stack structure includes channel patterns and insulating patterns alternately stacked, and the dummy stack structure includes dummy channel patterns and dummy patterns alternately stacked.

In an embodiment of the inventive concept, a semiconductor device includes: a substrate including a first region and a second region spaced apart from the first region; a cell stack structure that is in contact with the first region; a peripheral gate insulating layer that is in contact with the second region; a peripheral gate electrode on the peripheral gate insulating layer; a peripheral gate capping layer on the peripheral gate electrode; a liner covering the peripheral gate capping layer; and a peripheral gate contact penetrating (i.e., extending in) the liner and the peripheral gate capping layer and contacting the peripheral gate electrode, wherein the cell stack structure includes: a data storage structure; a bit line spaced apart from the data storage structure; channel patterns between the bit line and the data storage structure and overlapping each other; and a word line between the bit line and the data storage structure.

In an embodiment of the inventive concept, a method of manufacturing a semiconductor device includes: providing a substrate including a first region and a second region spaced apart from the first region; forming a sacrificial layer and a preliminary channel layer on the substrate; etching the preliminary channel layer and the sacrificial layer, wherein the preliminary channel layer is divided into a preliminary channel pattern overlapping the first region and a sacrificial channel pattern overlapping the second region by being etched, and the sacrificial layer is divided into a sacrificial pattern overlapping the first region and a dummy sacrificial pattern overlapping the second region by being etched; forming a word line hole (i.e., opening) to divide the preliminary channel pattern into channel patterns; replacing the sacrificial pattern with an insulating pattern; forming a word line in the word line hole; exposing the second region by removing the sacrificial channel pattern and the dummy sacrificial pattern; and forming a peripheral gate structure on the second region.

In an embodiment of the inventive concept, a method of manufacturing a semiconductor device includes: providing a substrate including a first region and a second region spaced apart from the first region; forming a cell stack structure on the first region and forming a dummy stack structure on the second region; forming a semiconductor structure on the cell stack structure and the dummy stack structure; and forming a peripheral gate structure on the semiconductor structure.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings, wherein like reference numerals (when used) indicate corresponding elements throughout the several views:
FIG. 1 is schematic circuit diagram illustrating a semiconductor device according to some embodiments;
FIG. 2A is a schematic plan view of a semiconductor device according to some embodiments;
FIG. 2B is a schematic cross-sectional view taken along line A1-A1' of FIG. 2A;
FIG. 2C is a schematic cross-sectional view taken along line B 1-B 1' of FIG. 2A;
FIG. 2D is a schematic cross-sectional view taken along line C1-C1' of FIG. 2A;
FIG. 2E is a schematic cross-sectional view taken along line D1-D1' of FIG. 2A;
FIGS. 3, 4, 5, 6, 7, 8, 9A, 9B, 10A, and 10B are schematic cross-sectional views illustrating intermediate processes in an example method of manufacturing the semiconductor device according to one or more embodiments shown in FIGS. 2A to 2E;
FIG. 11 is a schematic cross-sectional view illustrating a method of manufacturing the semiconductor device according to FIGS. 2A to 2E;
FIGS. 12A and 12B are schematic cross-sectional views of a semiconductor device according to some embodiments;
FIGS. 13 and 14 are schematic cross-sectional views illustrating a method of manufacturing the semiconductor device according to FIGS. 12A and 12B;
FIG. 15A is a schematic plan view of a semiconductor device according to some embodiments;
FIG. 15B is a schematic cross-sectional view taken along line A2-A2' of FIG. 15A; and
FIG. 15C is a schematic cross-sectional view taken along line B2-B2' of FIG. 15A.

### DETAILED DESCRIPTION

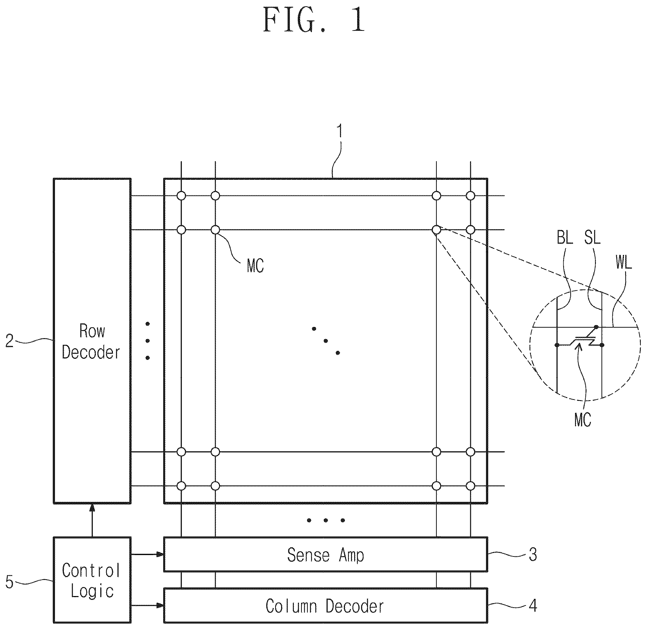

FIG. 1 is schematic circuit diagram illustrating a semiconductor device according to some embodiments.

Referring to FIG. 1, the semiconductor device may include a memory cell array 1, a row decoder 2, a sense amplifier 3, a column decoder 4, and a control logic 5.

The memory cell array 1 may include word lines WL, bit lines BL, source lines SL, and memory cells MC. The memory cells MC may be three-dimensionally arranged, and each of the memory cells MC may be connected to one word line WL, one bit line BL, and one source line SL. In some embodiments, the memory cells MC may be each configured with one transistor including a memory layer (or data storage layer).

The row decoder 2 may be configured to decode an external input address and select any one of the word lines WL of the memory cell array 1 as a function of the input address. The address decoded by the row decoder 2 may be provided to a row driver (not explicitly shown), and the row driver may provide predetermined voltages to a selected word line WL and non-selected word lines WL respectively in response to control by control circuits.

The sense amplifier 3 may sense and amplify a voltage difference between a reference bit line and the bit line BL selected according to an address decoded by the column decoder 4 and output the amplified voltage difference.

The column decoder 4 may provide a data transmission path between the sense amplifier 3 and an external device (e.g., a memory controller). The column decoder 4 may decode an external input address and select any one of the bit lines BL.

The control logic 5 may generate control signals for controlling operations of writing or reading data to or from the memory cell array 1.

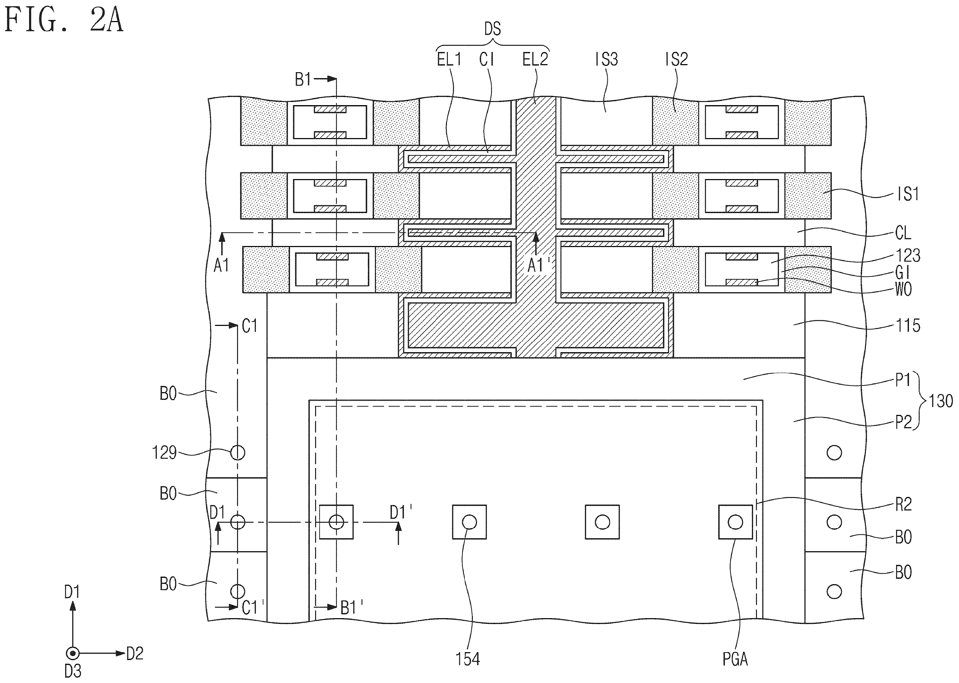

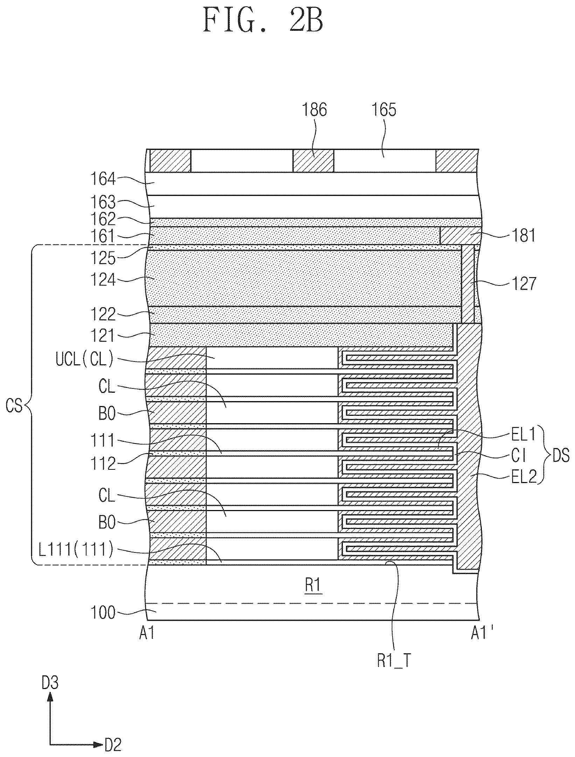

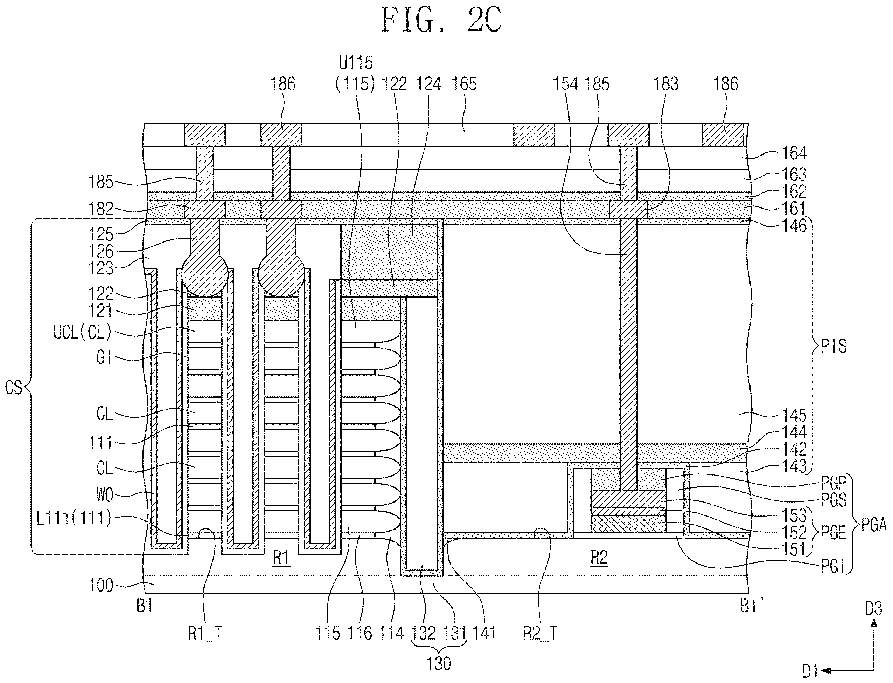

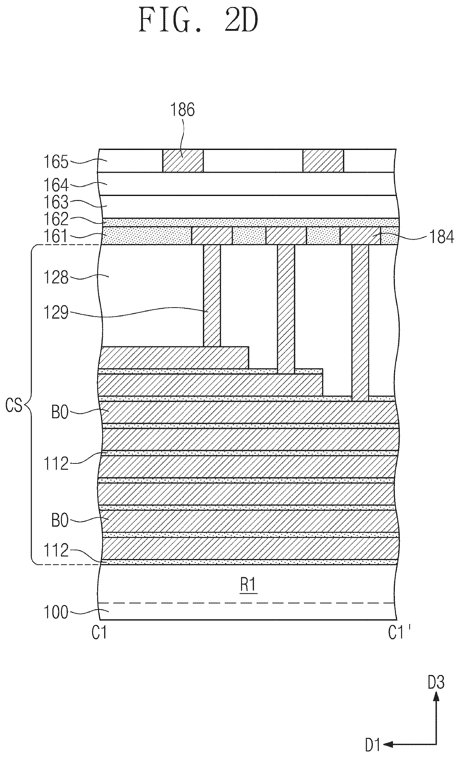

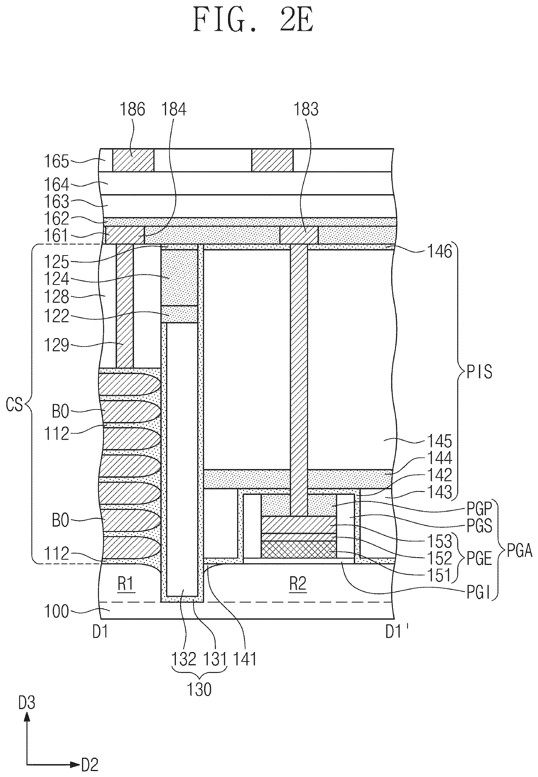

FIG. 2A is a schematic plan view of a semiconductor device according to some embodiments. FIG. 2B is a schematic cross-sectional view taken along line A1-A1' of FIG. 2A. FIG. 2C is a schematic cross-sectional view taken along line B1-B1' of FIG. 2A. FIG. 2D is a schematic cross-sectional view taken along line C1-C1' of FIG. 2A. FIG. 2E is a schematic cross-sectional view taken along line D1-D1' of FIG. 2A.

Referring to FIGS. 2A to 2E (collectively), the semiconductor device may include a substrate 100. The substrate 100 may have a shape of a plate extending along a plane defined by a first direction D1 and a second direction D2. The first direction D1 and the second direction D2 may intersect each other. For example, the first direction D1 and the second direction D2 may be horizontal directions perpendicular to each other and parallel to an upper surface of the substrate 100.

The substrate 100 may be a semiconductor substrate. For example, the substrate 100 may include silicon, germanium, or silicon-germanium, although embodiments are not limited thereto. In some embodiments, the substrate 100 may be a silicon-on-insulator (SOI) substrate or germanium-on-insulator (GOI) substrate.

The substrate 100 may include a first region R1 and a second region R2 spaced apart from each other. The first region R1 and the second region R2 may be upper portions of the substrate 100. The first region R1 and the second region R2 may be regions divided in a plan view defined by the first direction D1 and the second direction D2. The second region R2 may be disposed between bit lines BO that will be described later.

A cell stack structure CS may be provided on the first region R1 of the substrate 100. A lower surface of the cell stack structure CS may be in contact with an upper surface R1_T of the first region R1 of the substrate 100. The term "contact" (or "contacting," or like terms, such as "connect" or "connecting"), as may be used herein, is intended to refer to a physical and/or electrical connection between two or more elements, and may include other intervening elements. As used herein, the term "and/or" includes any and all combinations of one or more of the associated listed items. The cell stack structure CS may include bit lines BO, word lines WO, a word line capping layer 123, gate insulating layers GI, insulating patterns 111, channel patterns CL, bit line insulating patterns 112, first insulating structures IS 1, second insulating structures IS2, third insulating structures IS3, a data storage structure DS, outer channel patterns 115, outer insulating patterns 116, interposed patterns 114, a first cell insulating layer 121, a second cell insulating layer 122, a third cell insulating layer 124, a fourth cell insulating layer 125, word line contacts 126, bit line contacts 129, a bit line capping layer 128, and a data contact 127.

The data storage structure DS may be a capacitor including first electrodes EL1, a second electrode EL2, and capacitor insulating layers CI. The first electrodes EL1 may be spaced apart from the second electrode EL2. The capacitor insulating layer CI may be provided between the first electrode EL1 and the second electrode EL2.

The first electrodes EL1 may be provided on two (opposing) sides of the second electrode EL2. The capacitor insulating layers CI may be provided on two (opposing) sides of the second electrode EL2. The first and second electrodes EL1 and EL2 may include a conductive material. The capacitor insulating layer CI may include an insulating material.

In some embodiments, the data storage structure DS may be a variable resistor pattern capable of switching between two resistance states due to electrical pulses. In this case, the data storage structure DS may include phase-change materials, perovskite compounds, transition metal oxides, magnetic materials, ferromagnetic materials, or antiferromagnetic materials of which crystal states are changed according to an amount of current.

The channel patterns CL and the insulating patterns 111 may be alternately stacked in a third direction D3. The third direction D3 may intersect the first direction D1 and the second direction D2. For example, the third direction D3 may be a vertical direction perpendicular to the first direction D1 and the second direction D2, and perpendicular to the upper surface of the substrate 100.

The channel patterns CL may include channel patterns CL overlapping each other in the third direction D3. The term "overlapping" (or "overlap," or like terms), as may be used herein, is intended to broadly refer to a first element that intersects with at least a portion of a second element in the vertical direction (i.e., third direction D3), but does not require that the first and second elements be completely aligned with one another in a horizontal plane (i.e., first direction D1 and/or second direction D2). The channel pattern CL may be electrically connected to the data storage structure DS. The channel pattern CL may include first source/drain regions, a channel region, and second source/drain regions. The second source/drain regions of the channel pattern CL may be in contact with the first electrode EL1 of the data storage structure DS. The channel pattern CL may be arranged between the bit line BO and the data storage structure DS. The first and second source/drain regions may be doped with impurities.

The channel patterns CL overlapping each other in the third direction D3 may include channel patterns CL arranged at the same level as a peripheral gate structure PGA that will be described later and channel patterns CL arranged at a higher level than that of the peripheral gate structure PGA, relative to the upper surface of the substrate 100 as a reference layer.

The channel pattern CL may include at least one of a single crystalline semiconductor, a polycrystalline semiconductor, an oxide semiconductor, or a two-dimensional material, although embodiments are not limited thereto. The single crystalline semiconductor may be, for example, single crystalline silicon. The polycrystalline semiconductor may be, for example, polysilicon. The oxide semiconductor may be, for example, indium gallium zinc oxide (IGZO). The two-dimensional material may be, for example, molybdenum disulfide (MoS₂), tungsten disulfide (WS₂), molybdenum diselenide (MoSe₂), or tungsten diselenide (WSe₂).

The insulating pattern 111 may be provided between the channel patterns CL or between the channel pattern CL and the first region R1 of the substrate 100. A lowermost insulating pattern L111 among the insulating patterns 111 may be in contact with the upper surface R1_T of the first region R1 of the substrate 100. The insulating pattern 111 may include an insulating material. For example, the insulating pattern 111 may include an oxide.

The outer channel patterns 115 and the outer insulating patterns 116 may be alternately stacked in the third direction D3. The outer channel pattern 115 may include the same material as the channel pattern CL. The outer insulating pattern 116 may include the same material as the insulating pattern 111. The outer channel patterns 115 and the outer insulating patterns 116 may be adjacent to an isolation structure 130 that will be described later. The outer channel patterns 115 and the outer insulating patterns 116 may be adjacent to the second region R2.

The outer channel patterns 115 and the interposed patterns 114 may be alternately arranged in the third direction D3. The interposed patterns 114 may be provided between the outer channel patterns 115 or between the outer channel pattern 115 and the first region R1 of the substrate 100. A sidewall of the interposed pattern 114 may be in contact with a sidewall of the isolation structure 130. The interposed pattern 114 may include an insulating material. For example, the interposed pattern 114 may include an oxide.

The bit lines BO and the bit line insulating patterns 112 may be alternately stacked in the third direction D3. The bit line BO may be electrically connected to the channel pattern CL. The bit line BO may be in contact with the first source/drain regions of the channel pattern CL. The bit lines BO may extend in the first direction D1. The bit lines BO may include bit lines BO overlapping each other in the third direction D3. The bit lines BO may be spaced apart from the data storage structure DS. The data storage structure DS may be disposed between the bit lines BO. The bit lines BO may include a conductive material.

The bit line insulating patterns 112 may be provided between the bit lines BO or between the bit line BO and the first region R1 of the substrate 100. A lowermost bit line insulating pattern 112 among the bit line insulating patterns 112 may be in contact with the upper surface R1_T of the first region R1 of the substrate 100. The bit line insulating pattern 112 may include an insulating material. For example, the bit line insulating pattern 112 may include a nitride.

The bit line capping layer 128 may be provided on the bit lines BO. The bit line capping layer 128 may include an insulating material.

The gate insulating layer GI may be provided between the channel patterns CL adjacent to each other in the first direction D1 or between the channel pattern CL and the outer channel pattern 115 adjacent to each other in the first direction D1. The gate insulating layer GI may be provided between the data storage structure DS and the bit line BO. The gate insulating layer GI may be in contact with the channel patterns CL overlapping in the third direction D3. The gate insulating layer GI may extend in the third direction D3. The gate insulating layer GI may be in contact with the first region R1 of the substrate 100. The gate insulating layer GI may include an insulating material. For example, the gate insulating layer GI may include an oxide.

In some embodiments, the gate insulating layers GI, the insulating patterns 111, and the outer insulating patterns 115 may be connected to each other seamlessly, forming an integrated structure.

The word line WO may be provided between the channel patterns CL adjacent to each other in the first direction D1 or between the channel pattern CL and the outer channel pattern 115 adjacent to each other in the first direction D1. The word line WO may be provided on the gate insulating layer GI. The word line WO may extend in the third direction D3. The word line WO may be surrounded by the gate insulating layer GI in a plan view according to FIG. 2A. The term "surrounded" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. The word line WO may be provided between the data storage structure DS and the bit line BO. The word line WO may include a conductive material.

The word line capping layer 123 may be provided on the word lines WO. The word line capping layer 123 may include an insulating material. For example, the word line capping layer 123 may include an oxide.

The first insulating structure IS1 may be provided between the word line WO and the bit line BO. In some embodiments, the first insulating structure IS1 may be a multi-layer including a plurality of insulating layers.

The second insulating structure IS2 and the third insulating structure IS3 may be provided between the word line WO and the data storage structure DS. In some embodiments, the second insulating structure IS2 may be a multi-layer including a plurality of insulating layers. In some embodiments, the third insulating structure IS3 may be a multi-layer including a plurality of insulating layers.

The first cell insulating layer 121 may be provided on an uppermost channel pattern UCL among the channel patterns CL and an uppermost outer channel pattern U115 among the outer channel patterns 115. The first cell insulating layer 121 may be in contact with a sidewall of a first isolation layer 131, which will be described later, of the isolation structure 130 and the gate insulating layer GI.

The second cell insulating layer 122 may be provided on the first cell insulating layer 121. The second cell insulating layer 122 may be in contact with a sidewall of the first isolation layer 131 of the isolation structure 130 and the gate insulating layer GI. A lower surface of the second cell insulating layer 122 may be in contact with an upper surface of a second isolation layer 132, which will be described later, of the isolation structure 130. The second cell insulating layer 122 may be in contact with the word line contact 126.

The third cell insulating layer 124 may be provided on the second cell insulating layer 122. The third cell insulating layer 124 may be in contact with the word line capping layer 123 and a sidewall of the first isolation layer 131 of the isolation structure 130. The fourth cell insulating layer 125 may be provided on the third cell insulating layer 124 and the word line capping layer 123.

The first to fourth cell insulating layers 121, 122, 124, and 125 may include an insulating material. For example, the first to fourth cell insulating layers 121, 122, 124, and 125 may include a nitride.

The word line contact 126 may be in contact with the word line WO. The word line contact 126 may penetrate (i.e., extend in) the fourth cell insulating layer 125 and the word line capping layer 123. The word line contact 126 may be disposed at a higher level than that of the peripheral gate structure PGA, relative to the upper surface of the substrate 100. A distance between the word line contact 126 and the substrate 100 in the third direction D3 may be larger than a distance between the peripheral gate structure PGA and the substrate 100 in the third direction D3.

The bit line contact 129 may be in contact with the bit line BO. The bit line contact 129 may penetrate the bit line capping layer 128 in the third direction D3. At least one of the bit line contacts 129 may penetrate the bit line insulating pattern 112. The data contact 127 may be in contact with the second electrode EL2 of the data storage structure DS. The data contact 127 may penetrate the second to fourth cell insulating layers 122, 124, and 125 in the third direction D3. The data contact 127 may be disposed at a higher level than that of the peripheral gate structure PGA, relative to the upper surface of the substrate 100. The word line contact 126, the bit line contact 129, and the data contact 127 may include a conductive material.

The peripheral gate structure PGA may be provided on the second region R2 of the substrate 100. The peripheral gate structure PGA may be in contact with an upper surface R2_T of the second region R2 of the substrate 100. The peripheral gate structure PGA may include a peripheral gate insulating layer PGI that is in contact with the upper surface R2_T of the second region R2 of the substrate 100, a peripheral gate electrode PGE on the peripheral gate insulating layer PGI, a peripheral gate capping layer PGP on the peripheral gate electrode PGE, and peripheral gate spacers PGS on sidewalls of the peripheral gate electrode PGE and peripheral gate capping layer PGP.

The peripheral gate insulating layer PGI may include an insulating material. For example, the peripheral gate insulating layer PGI may include an oxide. A lower surface of the peripheral gate insulating layer PGI may be in contact with the upper surface R2_T of the second region R2 of the substrate 100.

The peripheral gate electrode PGE may include a first gate electrode 151, a second gate electrode 152 on the first gate electrode 151, and a third gate electrode 153 on the second gate electrode 152. The first to third gate electrodes 151, 152, and 153 may include a conductive material. For example, the first gate electrode 151 may include polysilicon, and the second and third gate electrodes 152 and 153 may include metals.

The peripheral gate capping layer PGP may include an insulating material. For example, the peripheral gate capping layer PGP may include a nitride. The peripheral gate spacer PGS may include an insulating material. In some embodiments, the peripheral gate spacer PGS may be a multi-layer including a plurality of insulating layers.

Impurity (e.g., doped) regions may be provided on two (opposing) sides of the peripheral gate structure PGA. A peripheral transistor including the impurity regions and the peripheral gate structure PGA may be defined.

The isolation structure 130 may be provided between the peripheral gate structure PGA and the cell stack structure CS. The isolation structure 130 may include a first portion P1 extending in the second direction D2 and second portions P2 extending in the first direction D1. The first portion P1 of the isolation structure 130 may be disposed between the data storage structure DS and the peripheral gate structure PGA. The first portion P1 of the isolation structure 130 may be disposed between the word line WO and the peripheral gate structure PGA. The second portion P2 of the isolation structure 130 may be disposed between the bit line BO and the peripheral gate structure PGA. The second portions P2 of the isolation structure 130 may be connected to two sides of the first portion P1 of the isolation structure 130. The second region R2 of the substrate 100 may be disposed between the second portions P2 of the isolation structure 130. The peripheral gate structures PGA may be arranged between the second portions P2 of the isolation structure 130.

The isolation structure 130 may be provided between the first region R1 and second region R2 of the substrate 100. A lower surface of the isolation structure 130 may be in contact with the substrate 100. Sidewalls of the isolation structure 130 may be in contact with the first region R1 or second region R2 of the substrate 100. The isolation structure 130 may include the first isolation layer 131 and the second isolation layer 132 in the first isolation layer 131. The first isolation layer 131 and the second isolation layer 132 may include different insulating materials. For example, the first isolation layer 131 may include an oxide, and the second isolation layer 132 may include a nitride.

A peripheral insulating structure PIS may be provided on the peripheral gate structure PGA. The peripheral insulating structure PIS may include a liner 142 on the peripheral gate structure PGA, a first peripheral insulating layer 143 on the liner 142, a second peripheral insulating layer 144 on the first peripheral insulating layer 143 and the liner 142, a third peripheral insulating layer 145 on the second peripheral insulating layer 144, and a fourth peripheral insulating layer 146 on the third peripheral insulating layer 145. The peripheral insulating structure PIS may surround (i.e., extend around) the peripheral gate structure PGA. The peripheral insulating structure PIS may surround at least a portion of a peripheral gate contact 154 that will be described later. At least some of the channel patterns CL may be arranged at the same level, in the third direction D3, as the peripheral insulating structure PIS relative to the upper surface of the substrate 100. A sidewall of the peripheral insulating structure PIS may be in contact with a sidewall of the isolation structure 130. The channel patterns CL overlapping in the third direction D3 may include channel patterns CL arranged at the same level as the peripheral gate structure PGA relative to the upper surface of the substrate 100.

The liner 142 may cover the peripheral gate capping layer PGP and peripheral gate spacer PGS of the peripheral gate structure PGA. The term "cover" (or "covering," "covers," or like terms), as may be used herein, is intended to broadly refer to an element, structure or layer that is on or over another element, structure or layer, either directly or with one or more other intervening elements, structures or layers therebetween. The liner 142 may be in contact with an upper surface of the peripheral gate capping layer PGP, an upper surface and sidewalls of the peripheral gate spacer PGS, sidewalls of the peripheral gate insulating layer PGI, and an upper surface of the second region R2 of the substrate 100. The liner 142 may have a fixed cross-sectional thickness, so as to conformally cover the peripheral gate structure PGA. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied. The liner 142 may include an insulating material. For example, the liner 142 may include a nitride.

An interposed insulating pattern 141 may be provided between the liner 142 and the second region R2 of the substrate 100. A lower surface of the interposed insulating pattern 141 may be in contact with the second region R2 of the substrate 100. An upper surface of the interposed insulating pattern 141 may be in contact with the liner 142. A sidewall of the interposed insulating pattern 141 may be in contact with the first isolation layer 131 of the isolation structure 130. The lower surface of the interposed insulating pattern 141 may be curved. The upper surface of the interposed insulating pattern 141 may be flat. The interposed insulating pattern 141 may include an insulating material. For example, the interposed insulating pattern 141 may include an oxide.

The first peripheral insulating layer 143 may surround the peripheral gate structure PGA. The first to fourth peripheral insulating layers 143, 144, 145, and 146 may include an insulating material. For example, the first and third peripheral insulating layers 143 and 145 may include an oxide, and the second and fourth peripheral insulating layers 144 and 146 may include a nitride.

The peripheral gate contact 154 may be provided, which penetrates the peripheral gate capping layer PGP, the liner 142, and the second to fourth peripheral insulating layers 144, 145, and 146. The peripheral gate contact 154 may be in contact with the peripheral gate electrode PGE of the peripheral gate structure PGA. The peripheral gate contact 154 may include a conductive material.

A length of the peripheral gate contact 154 in the third direction D3 may be larger than a length of the word line contact 126 in the third direction D3 and a length of the data contact 127 in the third direction D3. The length of the peripheral gate contact 154 in the third direction D3 may be larger than a length of at least one of the bit line contacts 129 in the third direction D3.

A first cover insulating layer 161 may be provided on the fourth cell insulating layer 125 of the cell stack structure CS and the fourth peripheral insulating layer 146 of the peripheral insulating structure PIS. A second cover insulating layer 162 may be provided on the first cover insulating layer 161. A third cover insulating layer 163 may be provided on the second cover insulating layer 162. A fourth cover insulating layer 164 may be provided on the third cover insulating layer 163. A fifth cover insulating layer 165 may be provided on the fourth cover insulating layer 164. The first to fifth cover insulating layers 161, 162, 163, 164, and 165 may include an insulating material. For example, the first and second cover insulating layers 161 and 162 may include a nitride, and the third to fifth cover insulating layers 163, 164, and 165 may include an oxide, although embodiments are not limited thereto.

A first conductive line 181, a second conductive line 182, a third conductive line 183, and a fourth conductive line 184 may be provided in the first cover insulating layer 161. A lower surface of the first conductive line 181 may be in contact with an upper surface of the data contact 127. A lower surface of the second conductive line 182 may be in contact with an upper surface of the word line contact 126. A lower surface of the third conductive line 183 may be in contact with an upper surface of the peripheral gate contact 154. A lower surface of the fourth conductive line 184 may be in contact with an upper surface of the bit line contact 129. The first to fourth conductive lines 181, 182, 183, and 184 may be arranged at the same vertical level relative to the upper surface of the substrate 100. The first to fourth conductive lines 181, 182, 183, and 184 may include a conductive material.

Conductive contacts 185 penetrating the second to fourth cover insulating layers 162, 163, and 164 may be provided. The conductive contact 185 may be in contact with one of the first to fourth conductive lines 181, 182, 183, and 184. The conductive contact 185 may include a conductive material.

Fifth conductive lines 186 may be provided in the fifth cover insulating layer 165. At least one of the fifth conductive lines 186 may be in contact with the conductive contact 185. The fifth conductive lines 186 may include a conductive material.

Since a peripheral transistor is provided on the second region R2 of the substrate 100 in the semiconductor device according to some embodiments, difficulty of a process of forming the peripheral transistor may be improved, and reliability of the semiconductor device may be improved.

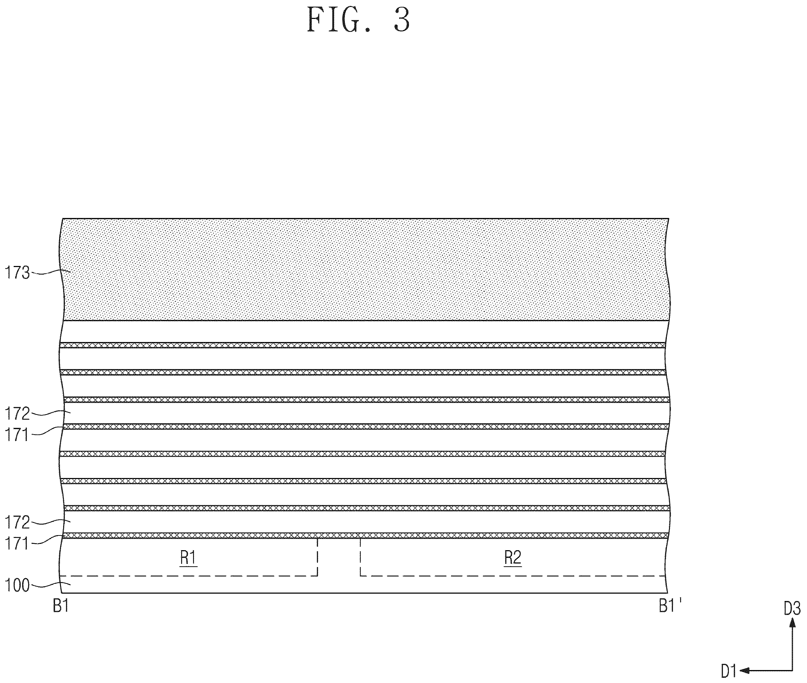

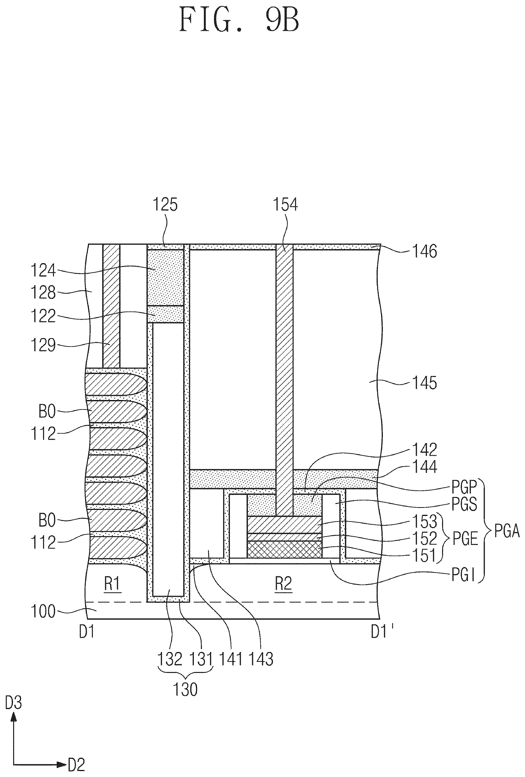

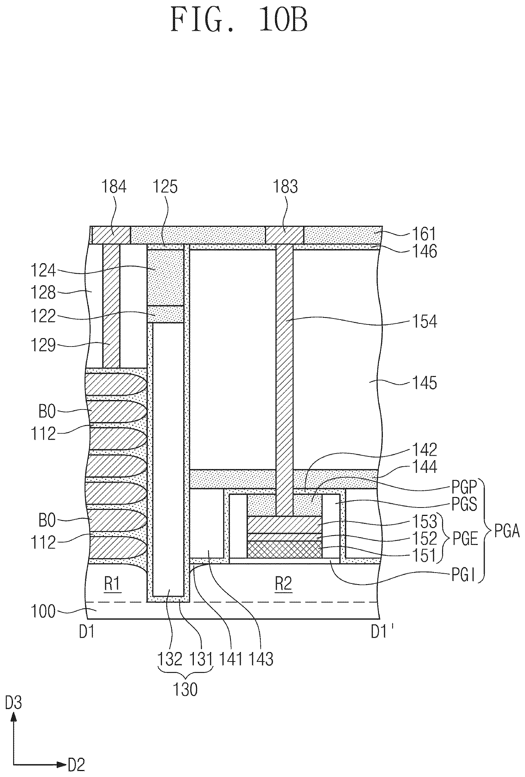

FIGS. 3, 4, 5, 6, 7, 8, 9A, 9B, 10A, and 10B are schematic cross-sectional views illustrating intermediate processes in an example method of manufacturing the semiconductor device according to FIGS. 2A to 2E. FIGS. 3, 4, 5, 6, 7, 8, 9A, and 10A may correspond to FIG. 2C. FIGS. 9B and 10B may correspond to FIG. 2E.

Referring to FIG. 3, the substrate 100 may be provided. The substrate 100 may include the first region R1 and the second region R2. Sacrificial layers 171 and preliminary channel layers 172 may be alternately formed on the substrate 100. The sacrificial layers 171 and the preliminary channel layers 172 may be alternately stacked in the third direction D3. The sacrificial layer 171 may have etch selectivity with respect to the preliminary channel layer 172. For example, the preliminary channel layer 172 may include silicon, and the sacrificial layer 171 may include silicon-germanium. A lowermost sacrificial layer 171 among the sacrificial layers 171 may be in contact with the upper surface of the first region R1 and second region R2 of the substrate 100.

A first preliminary insulating layer 173 may be formed on an uppermost preliminary channel layer 172 among the preliminary channel layers 172. The first preliminary insulating layer 173 may include an insulating material. For example, the first preliminary insulating layer 173 may include a nitride.

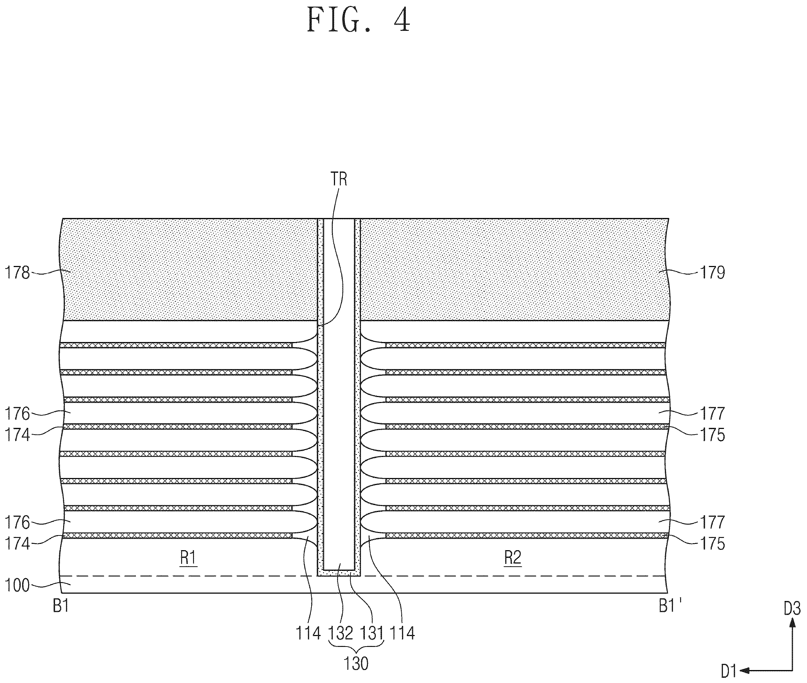

Referring to FIG. 4, the isolation structure 130 may be formed. Forming the isolation structure 130 may include forming a trench TR by etching the first preliminary insulating layer 173 (see FIG. 3), the sacrificial layers 171 (see FIG. 3), and the preliminary channel layers 172 (see FIG. 3) and forming the isolation structure 130 in the trench TR. A lower surface of the trench TR may be defined by a surface of the substrate 100.

The sacrificial layer 171 shown in FIG. 3 may be etched to be divided into a sacrificial pattern 174 and a dummy sacrificial pattern 175. The preliminary channel layer 172 shown in FIG. 3 may be etched to be divided into a preliminary channel pattern 176 and a sacrificial channel pattern 177. The first preliminary insulating layer 173 shown in FIG. 3 may be etched to be divided into a second preliminary insulating layer 178 and a third preliminary insulating layer 179.

The sacrificial patterns 174 and the preliminary channel patterns 176 may overlap the first region R1 of the substrate 100 in the third direction D3. The sacrificial patterns 174 and the preliminary channel patterns 176 may be alternately stacked in the third direction D3. The dummy sacrificial patterns 175 and the sacrificial channel patterns 177 may overlap the second region R2 of the substrate 100 in the third direction D3. The dummy sacrificial patterns 175 and the sacrificial channel patterns 177 may be alternately stacked in the third direction D3. The second preliminary insulating layer 178 may overlap the first region R1 of the substrate 100 in the third direction D3. The third preliminary insulating layer 179 may overlap the second region R2 of the substrate 100 in the third direction D3.

Before the isolation structure 130 is formed, the sacrificial patterns 174, the preliminary channel patterns 176, the dummy sacrificial patterns 175, and the sacrificial channel patterns 177 may be etched through the trench TR. The interposed patterns 114 may be formed in empty spaces formed by etching the sacrificial patterns 174, the preliminary channel patterns 176, the dummy sacrificial patterns 175, and the sacrificial channel patterns 177. After the interposed patterns 114 are formed, the first isolation layer 131 may be formed, and the second isolation layer 132 may be formed in the first isolation layer 131.

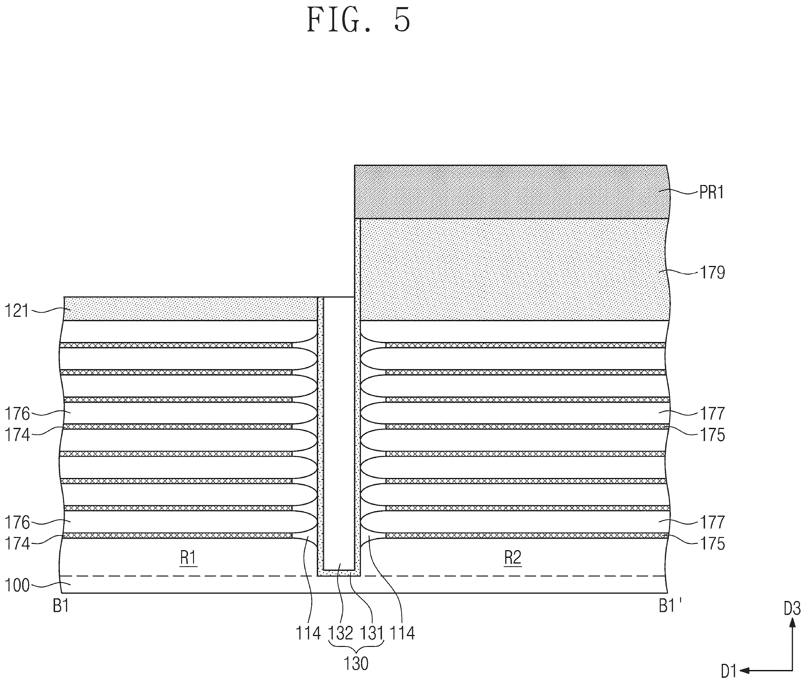

Referring to FIG. 5, a first photoresist pattern PR1 may be formed. The first photoresist pattern PR1 may be formed on the third preliminary insulating layer 179. The first photoresist pattern PR1 may overlap the second region R2 of the substrate 100 in the third direction D3. For example, the first photoresist pattern PR1 may overlap an entirety of the second region R2 of the substrate 100 in the third direction D3. The first photoresist pattern PR1 may not overlap the first region R1 of the substrate 100 in the third direction D3.

A first etching process may be performed using the first photoresist pattern PR1 as an etching mask. Through the first etching process, the second preliminary insulating layer 178 (see FIG. 4) and the isolation structure 130 may be etched. The etched second preliminary insulating layer 178 may be defined as the first cell insulating layer 121.

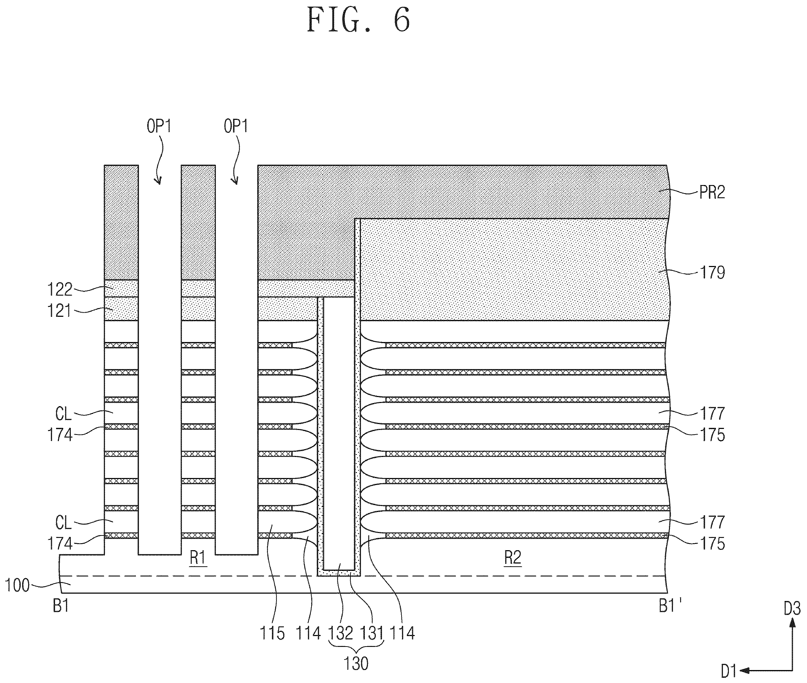

Referring to FIG. 6, the second cell insulating layer 122 may be formed on the first cell insulating layer 121 and the isolation structure 130. A second photoresist pattern PR2 may be formed on the third preliminary insulating layer 179 and the second cell insulating layer 122. The second photoresist pattern PR2 may overlap the second region R2 of the substrate 100 in the third direction D3. For example, the second photoresist pattern PR2 may overlap the entirety of the second region R2 of the substrate 100 in the third direction D3.

A second etching process may be performed using the second photoresist pattern PR2 as an etching mask. Word line holes (i.e., openings) OP1 may be formed through the second etching process. Through the second etching process, the preliminary channel pattern 176 (see FIG. 5) may be etched and divided into channel patterns CL and an outer channel pattern 115. Through the second etching process, the sacrificial pattern 174 may be etched and divided into a plurality of sacrificial patterns 174. Through the second etching process, the first cell insulating layer 121 and the second cell insulating layer 122 may be etched. Through the second etching process, a portion of the first region R1 of the substrate 100 may be etched. The word line hole OP1 may extend in the third direction D3. A lower surface of the word line hole OP1 may be defined by a surface of the first region R1 of the substrate 100.

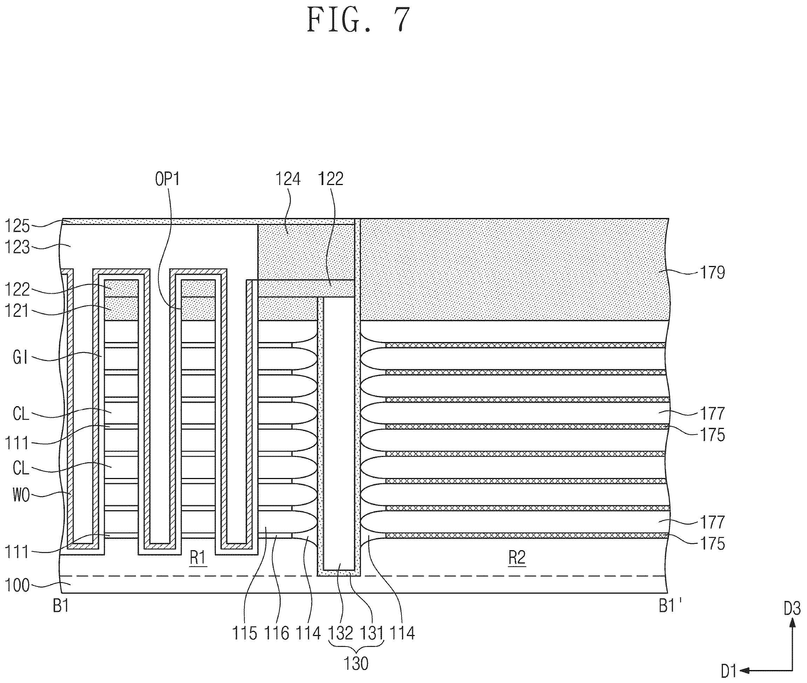

Referring to FIG. 7, the sacrificial patterns 174 (see FIG. 6) may be replaced with the insulating patterns 111 and the outer insulating patterns 116. The sacrificial patterns 174 may be removed, and the insulating patterns 111 and the outer insulating patterns 116 may be formed in empty spaces formed due to removal of the sacrificial patterns 174. The gate insulating layer GI may be formed. In some embodiments, the insulating patterns 111, the outer insulating patterns 116, and the gate insulating layer GI may be formed through a single deposition process.

The word line WO may be formed on the gate insulating layer GI. The word line WO may be formed in the word line hole OP1. The word line capping layer 123 may be formed on the word line WO. The third cell insulating layer 124 may be formed on the second cell insulating layer 122. The fourth cell insulating layer 125 may be formed on the third cell insulating layer 124 and the word line capping layer 123.

The bit lines BO, the bit line insulating patterns 112, the bit line capping layer 128, the first insulating structure IS1, the second insulating structure IS2, the third insulating structure IS3, and the data storage structure DS may be formed (FIGS. 2A to 2E).

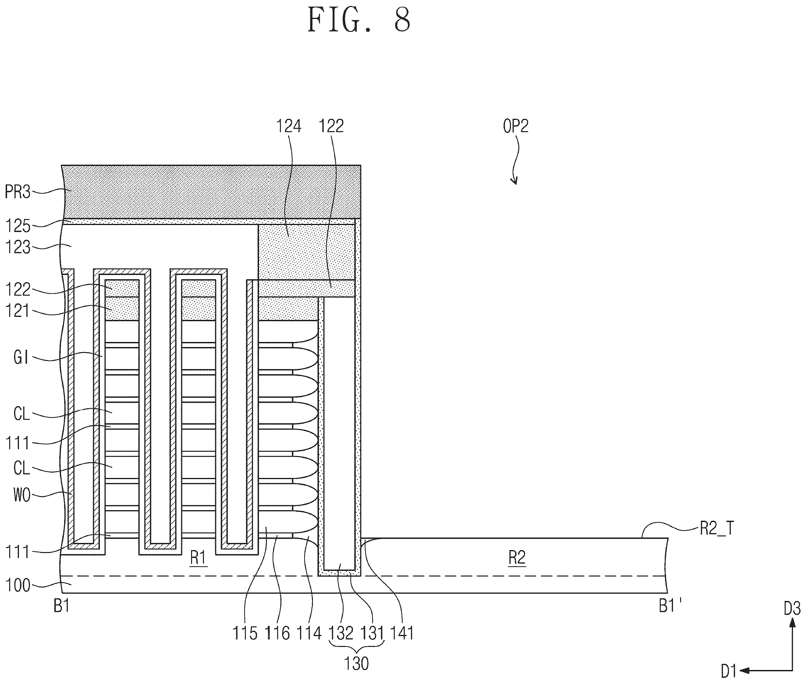

Referring to FIG. 8, a third photoresist pattern PR3 may be formed on the fourth cell insulating layer 125. The third photoresist pattern PR3 may overlap the first region R1 of the substrate 100 in the third direction D3. The third photoresist pattern PR3 may not overlap the second region R2 of the substrate 100 in the third direction D3.

A third etching process may be performed using the third photoresist pattern PR3 as an etching mask. An opening OP2 may be formed through the third etching process. The opening OP2 may expose the upper surface R2_T of the second region R2 of the substrate 100. The term "expose" (or "exposed," or like terms) may be used herein to describe relationships between elements and/or with reference to intermediate processes in fabricating an integrated circuit device, but may not require exposure of a particular element in the completed device. Likewise, the term "not exposed" may be used to described relationships between elements and/or with reference to intermediate processes in fabricating an integrated circuit device, but may not require a particular element to be unexposed in the completed device.

The third preliminary insulating layer 179, the sacrificial channel patterns 177, and the dummy sacrificial patterns 175 (see FIG. 7) may be removed through the third etching process. Through the third etching process, some of the interposed patterns 114 overlapping the second region R2 of the substrate 100 in the third direction D3 may be removed. A lowermost interposed pattern 114 among the interposed patterns 114 overlapping the second region R2 of the substrate 100 in the third direction D3 may be etched through the third etching process, thus forming the interposed insulating pattern 141. A sidewall of the isolation structure 130 may be exposed through the third etching process.

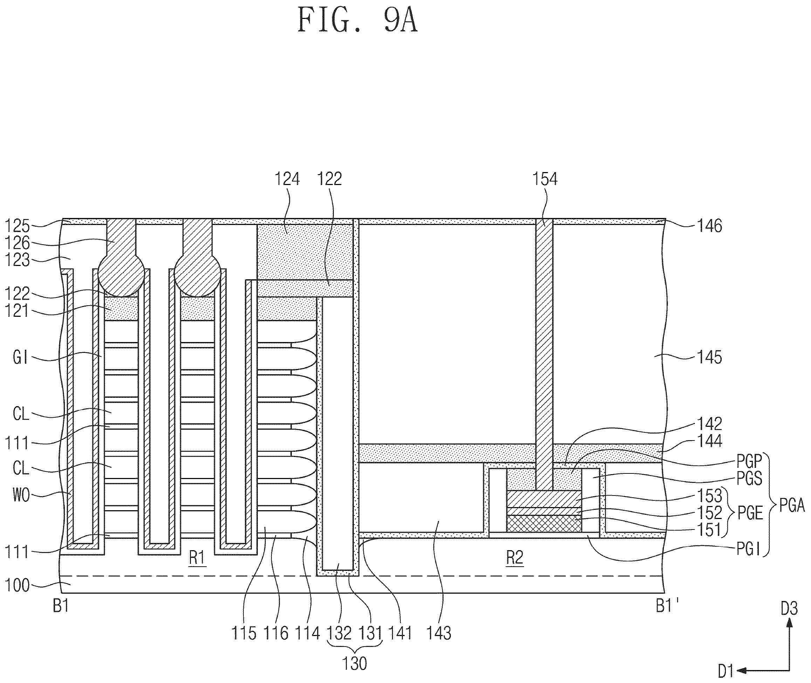

Referring to FIGS. 9A and 9B, the peripheral gate insulating layer PGI may be formed on the second region R2 of the substrate 100. The peripheral gate electrode PGE may be formed on the peripheral gate insulating layer PGI. The peripheral gate capping layer PGP may be formed on the peripheral gate electrode PGE. The peripheral gate spacers PGS may be formed on sidewalls of the peripheral gate electrode PGE and peripheral gate capping layer PGP. The liner 142 covering the peripheral gate capping layer PGP and the peripheral gate spacers PGS may be formed. The first peripheral insulating layer 143 may be formed on the liner 142.

The second peripheral insulating layer 144 may be formed on the first peripheral insulating layer 143. The third peripheral insulating layer 145 may be formed on the second peripheral insulating layer 144. The fourth peripheral insulating layer 146 may be formed on the third peripheral insulating layer 145.

The word line contact 126, the bit line contact 129, and the peripheral gate contact 154 may be formed. In some embodiments, the word line contact 126, the bit line contact 129, and the peripheral gate contact 154 may be simultaneously formed through a single process. In some embodiments, the word line contact 126 and the bit line contact 129 may be formed before the third photoresist pattern PR3 is formed.

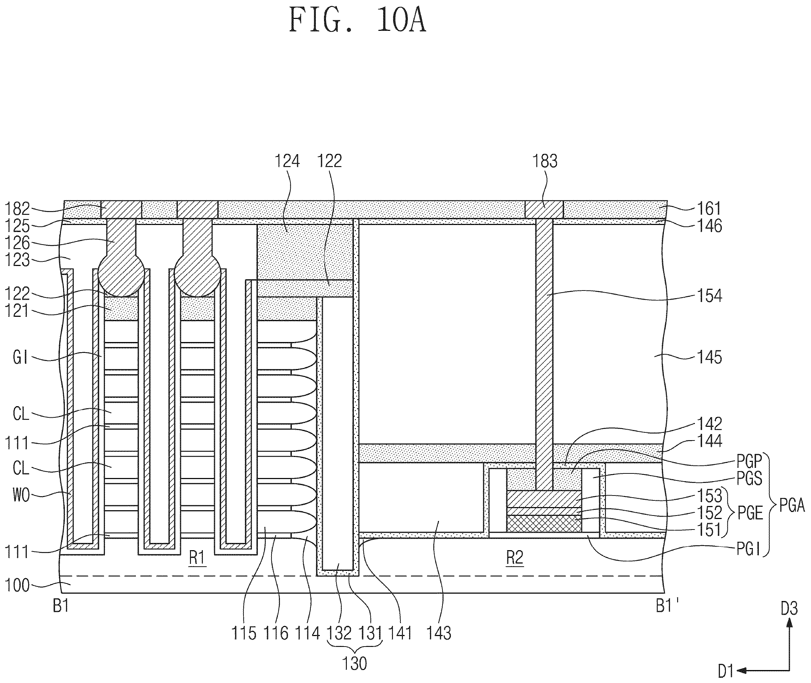

Referring to FIGS. 10A and 10B, the first cover insulating layer 161 may be formed. The first conductive line 181 (FIG. 2B), the second conductive line 182, the third conductive line 183, and the fourth conductive line 184 may be formed in the first cover insulating layer 161. In some embodiments, the first to fourth conductive lines 181, 182, 183, and 184 may be simultaneously formed through a single process.

Referring to FIGS. 2A to 2E, the second cover insulating layer 162 may be formed on the first cover insulating layer 161. The third cover insulating layer 163 and the fourth cover insulating layer 164 may be sequentially formed on the second cover insulating layer 162. The conductive contacts 185 penetrating the second to fourth cover insulating layers 162, 163, and 164 may be formed. The fifth cover insulating layer 165 may be formed on the fourth cover insulating layer 164. The fifth conductive lines 186 may be formed in the fifth cover insulating layer 165.

In a method of manufacturing a semiconductor device according to some embodiments, the second region R2 of the substrate 100 may be exposed, and the peripheral gate structure PGA may be formed on the second region R2 of the substrate 100. Since the second region R2 of the substrate 100 has a relatively large thickness, stability of a process of forming the peripheral gate structure PGA may be improved, and reliability of the semiconductor device may be improved.

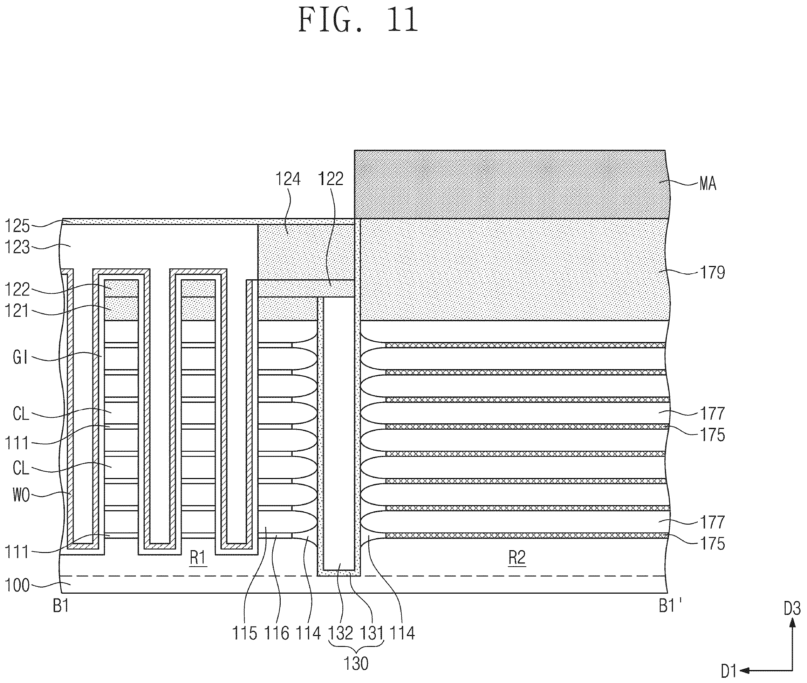

FIG. 11 is a schematic cross-sectional view illustrating an intermediate process in a method of manufacturing the semiconductor device according to FIGS. 2A to 2E.

Referring to FIG. 11, the substrate 100, the sacrificial patterns 174 (see FIG. 5), the preliminary channel patterns 176 (see FIG. 4), the dummy sacrificial patterns 175, the sacrificial channel patterns 177, the second preliminary insulating layer 178 (see FIG. 4), the third preliminary insulating layer 179, and the isolation structure 130 may be formed in a similar manner to the descriptions provided with reference to FIGS. 3 and 4.

A mask layer MA may be formed on the third preliminary insulating layer 179. The mask layer MA may overlap the second region R2 in the third direction D3. For example, the mask layer MA may overlap the entirety of the second region R2 in the third direction D3.

A cell manufacturing process may be performed to form the channel patterns CL, the insulating patterns 111, the outer channel patterns 115, the outer insulating patterns 116, the first cell insulating layer 121, the second cell insulating layer 122, the gate insulating layer GI, the word line WO, the word line capping layer 123, the third cell insulating layer 124, and the fourth cell insulating layer 125 in a similar manner to the descriptions provided with reference to FIGS. 5 to 7.

During the cell manufacturing process, the mask layer MA may protect the dummy sacrificial patterns 175, the sacrificial channel patterns 177, and the third preliminary insulating layer 179. The mask layer MA may be removed after the cell manufacturing process is performed.

Thereafter, the third preliminary insulating layer 179, the sacrificial channel patterns 177, and the dummy sacrificial patterns 175 may be removed and the peripheral gate structure PGA may be formed in a similar manner to the descriptions provided with reference to FIGS. 8, 9A, and 9B.

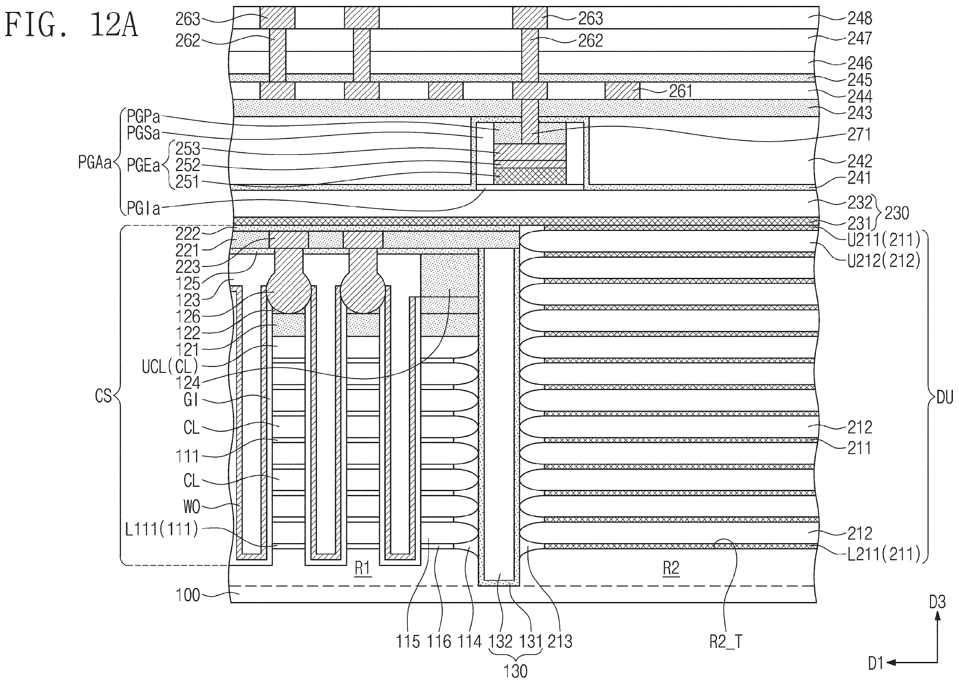

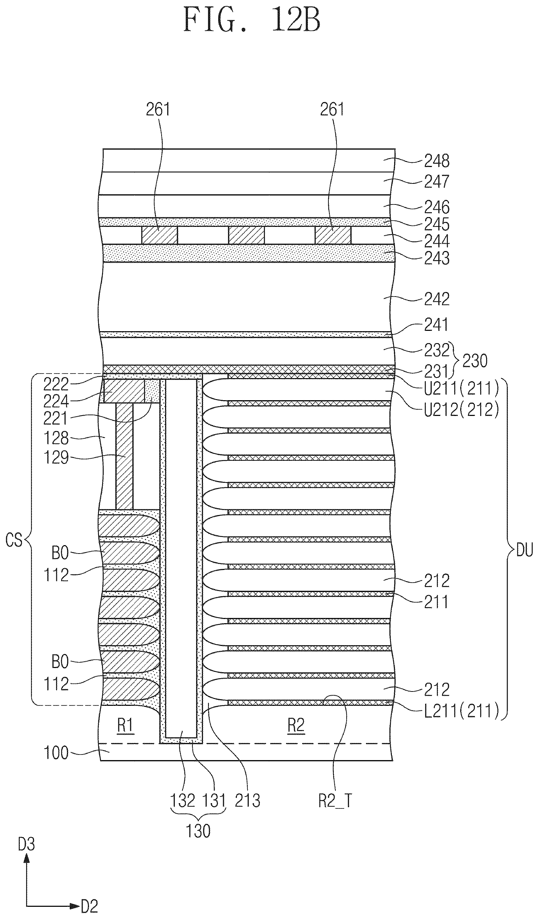

FIGS. 12A and 12B are schematic cross-sectional views of a semiconductor device according to some embodiments. The semiconductor device according to FIGS. 12A and 12B may be similar to the semiconductor device according to FIGS. 2A to 2E except for matters described below.

Referring to FIGS. 12A and 12B, a dummy stack structure DU may be provided on the second region R2 of the substrate 100. A lower surface of the dummy stack structure DU may be in contact with the upper surface R2_T of the second region R2 of the substrate 100.

The dummy stack structure DU may include dummy patterns 211 and dummy channel patterns 212 alternately stacked in the third direction D3. The dummy patterns 211 may include a material having etch selectivity with respect to the dummy channel patterns 212. For example, the dummy patterns 211 may include silicon-germanium, and the dummy channel patterns 212 may include silicon. A lower surface of a lowermost dummy pattern L211 among the dummy patterns 211 may be in contact with the upper surface R2_T of the second region R2 of the substrate 100. Some of the dummy channel patterns 212 may be arranged at a higher level than the channel patterns CL, relative to the upper surface of the substrate 100. For example, an uppermost dummy channel pattern U212 among the dummy channel patterns 212 may be disposed at a higher level than the channel patterns CL.

The dummy stack structure DU may further include dummy interposed patterns 213. The dummy interposed patterns 213 and the dummy channel patterns 212 may be alternately arranged in the third direction D3. A sidewall of the dummy interposed pattern 213 may be in contact with a sidewall of the isolation structure 130. The dummy interposed pattern 213 may include an insulating material.

The cell stack structure CS may include a fifth cell insulating layer 221 on the fourth cell insulating layer 125 and a sixth cell insulating layer 222 on the fifth cell insulating layer 221. The fifth and sixth cell insulating layers 221 and 222 may include an insulating material. For example, the fifth and sixth cell insulating layers 221 and 222 may include a nitride.

The cell stack structure CS may include a first conductive line 223 and a second conductive line 224 in the fifth cell insulating layer 221. The first conductive line 223 may be connected to the word line contact 126. The second conductive line 224 may be connected to the bit line contact 129.

A semiconductor structure 230 may be provided on the cell stack structure CS and the dummy stack structure DU. The semiconductor structure 230 may include a seed layer 231 and a semiconductor layer 232 on the seed layer 231. A lower surface of the seed layer 231 may be in contact with an upper surface of the sixth cell insulating layer 222 and an upper surface of an uppermost dummy pattern U211 among the dummy patterns 211.

The seed layer 231 may be a polycrystalline semiconductor layer. For example, the seed layer 231 may include polysilicon. The semiconductor layer 232 may be formed through a growth process using the seed layer 231 as a seed. The semiconductor layer 232 may be a single-crystalline semiconductor layer. For example, the semiconductor layer 232 may include single-crystalline silicon.

A thickness of the semiconductor layer 232 in the third direction D3 may be larger than a thickness of the seed layer 231 in the third direction D3, a thickness of the channel pattern CL in the third direction, and a thickness of the dummy channel pattern 212 in the third direction D3.

A peripheral gate structure PGAa may be provided on an upper surface of the semiconductor layer 232 of the semiconductor structure 230. The peripheral gate structure PGAa may include a peripheral gate insulating layer PGIa, a peripheral gate electrode PGEa, a peripheral gate capping layer PGPa, and peripheral gate spacers PGSa. A lower surface of the peripheral gate insulating layer PGIa may be in contact with the upper surface of the semiconductor layer 232. The peripheral gate electrode PGEa may include a first gate electrode 251, a second gate electrode 252, and a third gate electrode 253. The first gate electrode 251, the second gate electrode 252, and the third gate electrode 253 may be sequentially stacked in the third direction D3. The peripheral gate structure PGAa may at least partially overlap the isolation structure 130 in the third direction D3.

A liner 241 covering the peripheral gate structure PGAa may be provided. The liner 241 may be in contact with the upper surface of the semiconductor layer 232. A first cover insulating layer 242 may be provided on the liner 241. A second cover insulating layer 243 may be provided on the first cover insulating layer 242 and the liner 241. The liner 241, the first cover insulating layer 242, and the second cover insulating layer 243 may include an insulating material. For example, the liner 241 and the second cover insulating layer 243 may include a nitride, and the first cover insulating layer 242 may include an oxide.

A peripheral gate contact 271 may be provided, which penetrates the second cover insulating layer 243, the liner 241, and the peripheral gate capping layer PGPa. The peripheral gate contact 271 may be in contact with the peripheral gate electrode PGEa.

A third cover insulating layer 244 may be provided on the second cover insulating layer 243. A fourth cover insulating layer 245, a fifth cover insulating layer 246, a sixth cover insulating layer 247, and a seventh cover insulating layer 248 may be sequentially provided on the third cover insulating layer 244 in the third direction D3. The third to seventh cover insulating layers 244, 245, 246, 247, and 248 may include an insulating material. For example, the third, fifth, sixth, and seventh cover insulating layers 244, 246, 247, and 248 may include an oxide, and the fourth cover insulating layer 245 may include a nitride, although embodiments are not limited thereto.

Third conductive lines 261 may be provided in the third cover insulating layer 244. One of the third conductive lines 261 may be in contact with the peripheral gate contact 271. Conductive contacts 262 penetrating the fourth to sixth cover insulating layers 245, 246, and 247 may be provided. The conductive contact 262 may be in contact with the third conductive line 261 contacting the peripheral gate contact 271, and thus the conductive contact 262 may be electrically connected to the peripheral gate electrode PGEa. Fourth conductive lines 263 may be provided in the seventh cover insulating layer 248. The fourth conductive lines 263 may be in contact with respective conductive contacts 262.

The third conductive line 261 may be disposed at a higher level than the first conductive line 223 and the second conductive line 224 relative to the upper surface of the substrate 100. The peripheral gate structure PGAa may be disposed between the first conductive line 223 and the third conductive line 261.

In the semiconductor device according to some embodiments, the semiconductor structure 230 may be disposed on the cell stack structure CS and the dummy stack structure DU, and the peripheral gate structure PGAa may be disposed on the semiconductor structure 230. Accordingly, difficulty of a process of forming the peripheral transistor may be improved, and reliability of the semiconductor device may be improved.

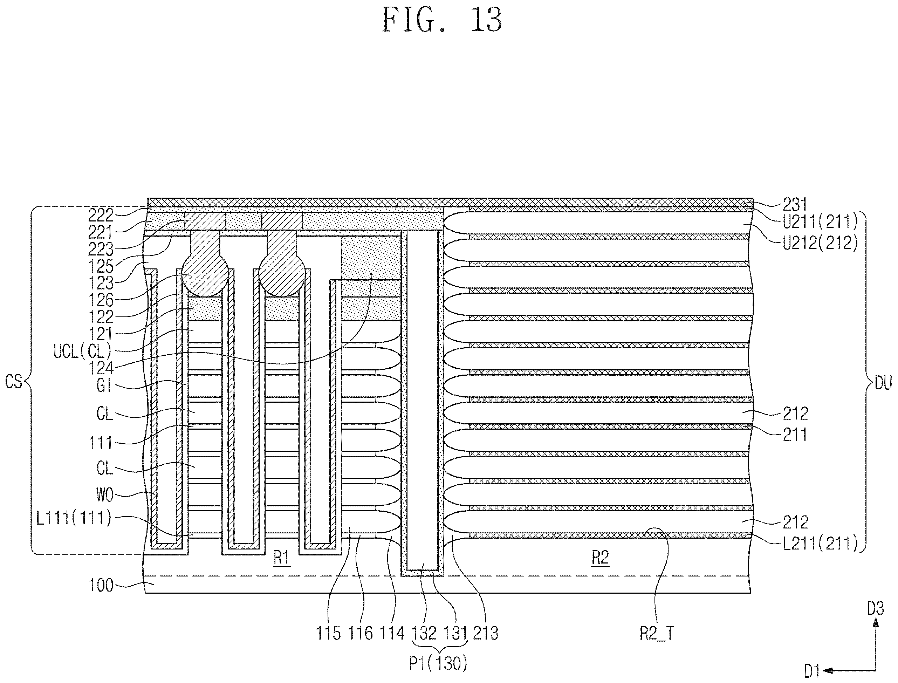

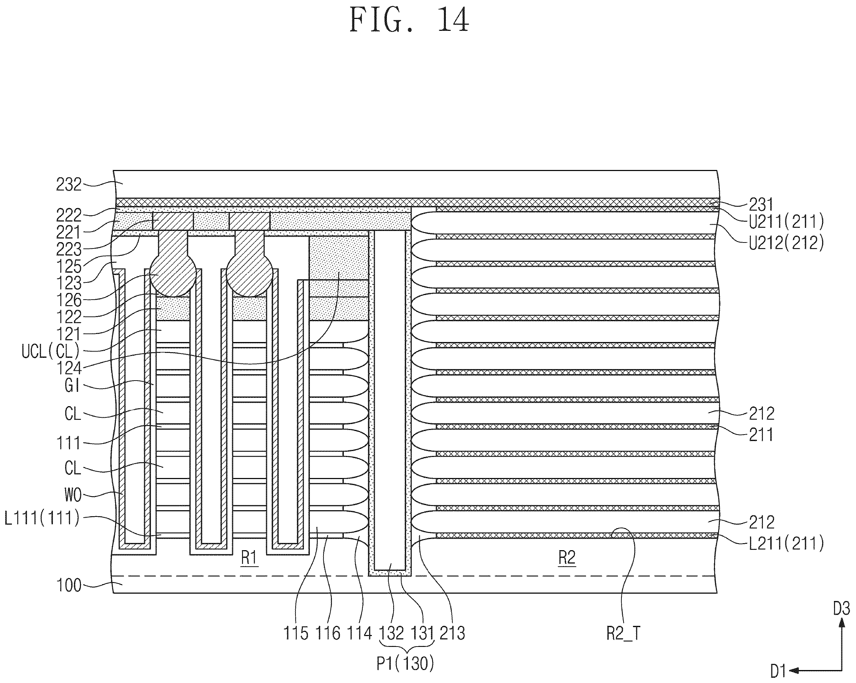

FIGS. 13 and 14 are schematic cross-sectional views illustrating intermediate processes in an example method of manufacturing the semiconductor device according to FIGS. 12A and 12B.

Referring to FIG. 13, the cell stack structure CS may be formed on the first region R1 of the substrate 100, and the dummy stack structure DU may be formed on the second region R2 of the substrate 100. Forming the dummy channel pattern 212 may include forming a preliminary channel layer and separating the preliminary channel layer into a preliminary channel pattern and the dummy channel pattern 212. Forming the dummy pattern 211 may include forming a sacrificial layer and separating the sacrificial layer into a sacrificial pattern and the dummy pattern 211. The preliminary channel layer, the preliminary channel pattern, the sacrificial layer, and the sacrificial pattern may be similar to those described with reference to FIGS. 3 and 4.

The seed layer 231 may be formed on the cell stack structure CS and the dummy stack structure DU.

Referring to FIG. 14, the semiconductor layer 232 may be formed on the seed layer 231. The semiconductor layer 232 may be formed through an epitaxial growth process using the seed layer 231 as a seed.

Referring to FIGS. 12A and 12B, the peripheral gate structure PGAa may be formed on the semiconductor layer 232. Thereafter, a subsequent process may be performed.

Since the peripheral gate structure PGAa is formed on the semiconductor layer 232 having a relatively large thickness in the method of manufacturing a semiconductor device according to some embodiments, stability of a process of forming the peripheral gate structure PGAa may be improved, and reliability of the semiconductor device may be improved.

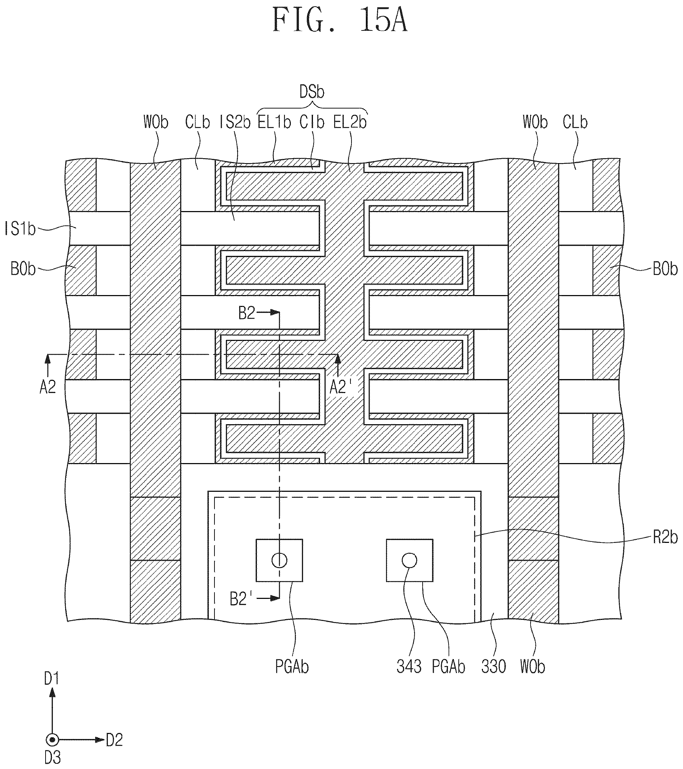

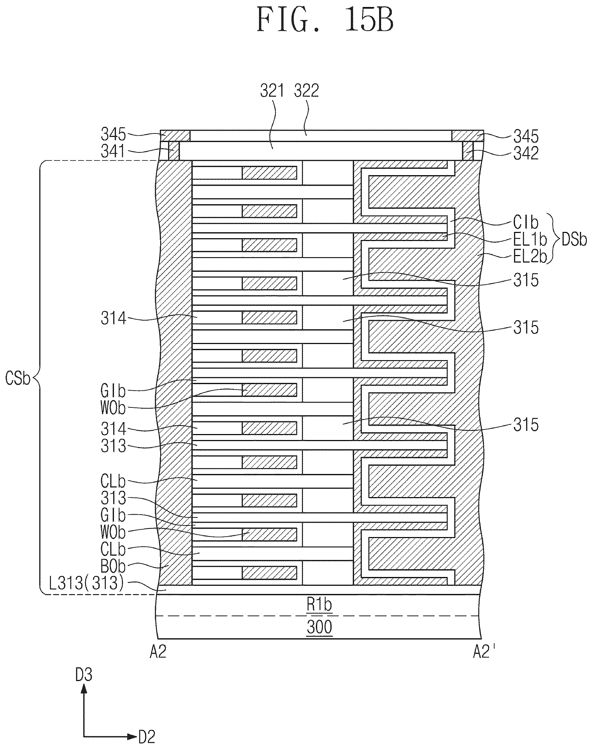

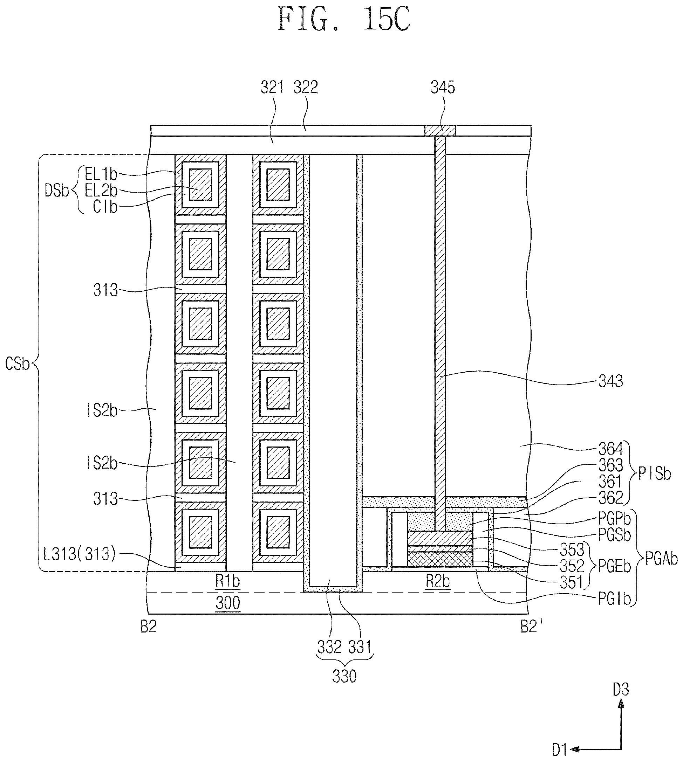

FIG. 15A is a schematic plan view of a semiconductor device according to some embodiments. FIG. 15B is a schematic cross-sectional view taken along line A2-A2' of FIG. 15A. FIG. 15C is a schematic cross-sectional view taken along line B2-B2' of FIG. 15A.

Referring to FIGS. 15A to 15C, the semiconductor device may include a substrate 300. The substrate 300 may include a first region R1b and a second region R2b spaced apart horizontally from each other. The second region R2b may be disposed between word lines WOb that will be described later.

A cell stack structure CSb may be provided on the first region R1b of the substrate 300. The cell stack structure CSb may include bit lines BOb, word lines WOb, gate insulating layers GIb, insulating patterns 313, first capping patterns 314, second capping patterns 315, channel patterns CLb, first insulating structures IS1b, second insulating structures IS2b, and a data storage structure DSb.

The data storage structure DSb may comprise a capacitor including first electrodes EL1b, a second electrode EL2b, and capacitor insulating layers CIb.

The bit lines BOb may extend in the third direction D3. The bit line BOb may be arranged on two (opposing) sides of the data storage structure DSb. The data storage structure DSb may be disposed between the bit lines BOb. The bit lines BOb arranged on one side of the data storage structure DSb may be arranged in the first direction D1.

The word lines WOb may be provided between the bit lines BOb and the data storage structure DSb. The word lines WOb may be provided on two sides of the data storage structure DSb. The data storage structure DSb may be disposed between the word lines WOb. The word lines WOb arranged on one side of the data storage structure DSb may overlap each other in the third direction D3. The word lines WOb may extend in the first direction D1.

The channel pattern CLb may electrically connect the bit line BOb to the data storage structure DSb. The channel patterns CLb overlapping each other in the third direction D3 may be electrically connected to a single bit line BOb.

The gate insulating layer GIb may be provided between the word line WOb and the channel pattern CLb. The first capping pattern 314 may be provided between the word line WOb and the bit line BOb. The word line WOb and the bit line BOb may be spaced apart (and electrically isolated from one another) due to the first capping pattern 314. The first capping pattern 314 may include an insulating material.

The second capping pattern 315 may be provided between the word line WOb and the data storage structure DSb. The word line WOb and the data storage structure DSb may be spaced apart (and electrically isolated from one another) due to the second capping pattern 315. The second capping pattern 315 may include an insulating material.

The first insulating structure IS1b may be provided between the bit lines BOb. The first insulating structures IS1b and the bit lines BOb may be alternately arranged in the first direction D1. The second insulating structure IS2b may be provided between the first electrodes EL1b. The second insulating structures IS2b and the first electrodes EL1b may be alternately arranged in the first direction D1.

The insulating patterns 313 and the channel patterns CLb may be alternately arranged in the third direction D3. A lower surface of a lowermost insulating pattern L313 among the insulating patterns 313 may be in contact with an upper surface of the first region R1b of the substrate 300.

A peripheral gate structure PGAb may be provided on the second region R2b of the substrate 300. The peripheral gate structure PGAb may be in contact with an upper surface of the second region R2b of the substrate 300. The peripheral gate structure PGAb may include a peripheral gate insulating layer PGIb, a peripheral gate electrode PGEb, a peripheral gate capping layer PGPb, and peripheral gate spacers PGSb. The peripheral gate electrode PGEb may include a first gate electrode 351, a second gate electrode 352, and a third gate electrode 353 sequentially stacked in the third direction D3.

An isolation structure 330 may be provided between the peripheral gate structure PGAb and the cell stack structure CSb. The isolation structure 330 may be provided between the first region R1b and second region R2b of the substrate 300. The isolation structure 330 may include a first isolation layer 331 and a second isolation layer 332 in the first isolation layer 331.

A peripheral insulating structure PISb may be provided on the peripheral gate structure PGAb. The peripheral insulating structure PISb may include a liner 361, a first peripheral insulating layer 362 on the liner 361, a second peripheral insulating layer 363 on the first peripheral insulating layer 362 and the liner 361, and a third peripheral insulating layer 364 on the second peripheral insulating layer 363.

A first cover insulating layer 321 may be provided on the cell stack structure CSb and the peripheral insulating structure PISb. A second cover insulating layer 322 may be provided on the first cover insulating layer 321.

A bit line contact 341 contacting the bit line BOb, a data contact 342 contacting the data storage structure DSb, and a peripheral gate contact 343 contacting the peripheral gate structure PGAb may be provided. A length of the peripheral gate contact 343 in the third direction D3 may be larger than a length of the bit line contact 341 in the third direction D3 and a length of the data contact 342 in the third direction D3.

Conductive lines 345 may be provided in the second cover insulating layer 322. The conductive lines 345 may be in contact with the bit line contact 341, the data contact 342, or the peripheral gate contact 343.

The semiconductor device according to embodiments of the inventive concept may make it possible to improve difficulty of a process of forming a peripheral transistor, thus improving the reliability of the semiconductor device.

Although the embodiments of the present invention have been described, it is understood that the present invention should not be limited to these embodiments but various changes and modifications can be made by one ordinary skilled in the art within the spirit and scope of the present invention as hereinafter claimed. Furthermore, embodiments of the inventive concept may be combined with each other.

## Claims

1. A semiconductor device, comprising:
a substrate including a first region and a second region spaced apart from the first region;
a cell stack structure on the first region; and
a peripheral gate structure on the second region,
wherein the cell stack structure includes:
channel patterns overlapping each other in a vertical direction perpendicular to an upper surface of the substrate;
a bit line electrically connected to at least one of the channel patterns and extending in a first direction parallel to the upper surface of the substrate; and
a word line extending in a second direction parallel to the upper surface of the substrate and intersecting the first direction.

2. The semiconductor device of claim 1, wherein the peripheral gate structure includes:
a peripheral gate insulating layer that is in contact with an upper surface of the second region; and
a peripheral gate electrode on the peripheral gate insulating layer.

3. The semiconductor device of claim 1, wherein the channel patterns include:
a first channel pattern at a same level as the peripheral gate structure in the vertical direction, relative to the upper surface of the substrate as a reference layer; and
a second channel pattern at a higher level than the peripheral gate structure, relative to the upper surface of the substrate.

4. The semiconductor device of claim 1, further comprising
an isolation structure between the cell stack structure and the peripheral gate structure,
wherein the isolation structure is between the first region and the second region.

5. The semiconductor device of claim 4, further comprising:
a liner on the peripheral gate structure; and
an interposed insulating pattern between the liner and the second region.

6. The semiconductor device of claim 5, wherein the interposed insulating pattern is in contact with a lower surface of the liner and a sidewall of the isolation structure.

7. The semiconductor device of claim 1,
wherein the cell stack structure further includes a word line contact in contact with the word line, and
the word line contact is at a higher level than the peripheral gate structure in the vertical direction, relative to the upper surface of the substrate.

8. The semiconductor device of claim 7, further comprising
a peripheral gate contact in contact with the peripheral gate structure,
wherein a length of the peripheral gate contact in the vertical direction is larger than a length of the word line contact in the vertical direction.

9. A method of manufacturing a semiconductor device, the method comprising:
providing a substrate including a first region and a second region spaced apart from the first region;
forming a sacrificial layer and a preliminary channel layer on the substrate;
etching the preliminary channel layer and the sacrificial layer, wherein the preliminary channel layer is divided into a preliminary channel pattern at least partially overlapping the first region in a vertical direction perpendicular to an upper surface of the substrate, and a sacrificial channel pattern at least partially overlapping the second region in the vertical direction by being etched, and the sacrificial layer is divided into a sacrificial pattern at least partially overlapping the first region in the vertical direction and a dummy sacrificial pattern at least partially overlapping the second region in the vertical direction by being etched;
forming a word line opening to divide the preliminary channel pattern into a plurality of channel patterns;
replacing the sacrificial pattern with an insulating pattern;
forming a word line in the word line opening;
exposing the second region by removing the sacrificial channel pattern and the dummy sacrificial pattern; and
forming a peripheral gate structure on the second region.

10. The method of claim 9, wherein removing the sacrificial channel pattern and the dummy sacrificial pattern includes:
forming a photoresist pattern; and
removing the sacrificial channel pattern and the dummy sacrificial pattern using the photoresist pattern as an etching mask,
wherein the photoresist pattern at least partially overlaps the first region in the vertical direction and does not overlap the second region in the vertical direction.

11. The method of claim 9, wherein forming the word line opening includes:
forming a photoresist pattern; and
forming the word line opening using the photoresist pattern as an etching mask,
wherein an entirety of the second region overlaps the photoresist pattern in the vertical direction.

12. The method of claim 9,
wherein etching the preliminary channel layer and the sacrificial layer includes:
forming a trench extending in the preliminary channel layer and the sacrificial layer; and
forming an isolation structure in the trench,
wherein the isolation structure is between the first region and the second region.

13. The method of claim 12, further comprising:
forming a photoresist pattern; and
etching the isolation structure using the photoresist pattern as an etching mask,
wherein the photoresist pattern overlaps an entirety of the second region in the vertical direction.

14. The method of claim 12, wherein removing the sacrificial channel pattern and the dummy sacrificial pattern includes exposing a sidewall of the isolation structure.

15. The method of claim 9, further comprising:
forming a word line contact in contact with the word line;
forming a peripheral gate contact in contact with the peripheral gate structure; and
simultaneously forming a first conductive line in contact with the word line contact and a second conductive line in contact with the peripheral gate contact.

## Amended claims

### Amended claims in accordance with Rule 137(2) EPC.

1. A semiconductor device, comprising:
a substrate (100) including a first region (R1) and a second region (R2) spaced apart from the first region (R1);
a cell stack structure (CS) on the first region (R1); and
a peripheral gate structure (PGA) on the second region (R2),
wherein the cell stack structure (CS) includes:
channel patterns (CL) overlapping each other in a vertical direction (D3) perpendicular to an upper surface of the substrate (100);
a bit line (BO) electrically connected to at least one of the channel patterns (CL) and extending in a first direction (D1) parallel to the upper surface of the substrate (100);
a word line (WO) extending in the vertical direction (D3); and
a gate insulating layer (GI) in contact with the channel patterns (CL) and the first region (R1) of the substrate (100),
wherein the channel patterns (CL) include:
a first channel pattern at a same level as the peripheral gate structure (PGA) in the vertical direction (D3), relative to the upper surface of the substrate (100) as a reference layer; and
a second channel pattern at a higher level than the peripheral gate structure (PGA) in the vertical direction (D3), relative to the upper surface of the substrate (100).

2. A semiconductor device, comprising:
a substrate (100) including a first region (R1) and a second region (R2) spaced apart from the first region (R1);
a cell stack structure (CS) on the first region (R1); and
a peripheral gate structure (PGAa),
wherein the cell stack structure (CS) includes:
channel patterns (CL) overlapping each other in a vertical direction (D3) perpendicular to an upper surface of the substrate (100);
a bit line (BO) electrically connected to at least one of the channel patterns (CL) and extending in a first direction (D1) parallel to the upper surface of the substrate (100);
a word line (WO) extending in the vertical direction (D3);
a gate insulating layer (GI) in contact with the channel patterns (CL) and the first region (R1) of the substrate (100);
a dummy stack structure (DU) on the second region (R2) of the substrate (100); and
a semiconductor structure (230) on the cell stack structure (CS) and the dummy stack structure (DU), the semiconductor structure (230) including a seed layer (231) and a semiconductor layer (232) on the seed layer (231),the peripheral gate structure (PGAa) being in contact with an upper surface of the semiconductor layer (232).

3. The semiconductor device of claim 1, wherein the peripheral gate structure (PGA) includes:
a peripheral gate insulating layer (PGI) that is in contact with an upper surface (R2_T) of the second region (R2); and
a peripheral gate electrode (PGE) on the peripheral gate insulating layer (PGI).

4. The semiconductor device of claim 1, further comprising
an isolation structure (130) between the cell stack structure (CS) and the peripheral gate structure (PGA),
wherein the isolation structure (130) is between the first region (R1) and the second region (R2).

5. The semiconductor device of claim 4, further comprising:a liner (142) on the peripheral gate structure (PGA); and
an interposed insulating pattern (141) between the liner (142) and the second region (R2).

6. The semiconductor device of claim 5, wherein the interposed insulating pattern (141) is in contact with a lower surface of the liner (142) and a sidewall of the isolation structure (130).

7. The semiconductor device of claim 1,
wherein the cell stack structure (CS) further includes a word line contact (126) in contact with the word line (WO), and
the word line contact (126) is at a higher level than the peripheral gate structure (PGA) in the vertical direction (D3), relative to the upper surface of the substrate (100).

8. The semiconductor device of claim 7, further comprising a peripheral gate contact (154) in contact with the peripheral gate structure (PGA), wherein a length of the peripheral gate contact (154) in the vertical direction (D3) is larger than a length of the word line contact (126) in the vertical direction (D3).

9. A method of manufacturing a semiconductor device, the method comprising:
providing a substrate (100) including a first region (R1) and a second region (R2) spaced apart from the first region (R1);
forming a sacrificial layer (171) and a preliminary channel layer (172) on the substrate (100);
etching the preliminary channel layer (172) and the sacrificial layer (171), wherein the preliminary channel layer (172) is divided into a preliminary channel pattern (176) at least partially overlapping the first region (R1) in a vertical direction (D3) perpendicular to an upper surface of the substrate (100), and a sacrificial channel pattern (177) at least partially overlapping the second region (R2) in the vertical direction (D3) by being etched, and the sacrificial layer (171) is divided into a sacrificial pattern (174) at least partially overlapping the first region (R1) in the vertical direction (D3) and a dummy sacrificial pattern (175) at least partially overlapping the second region (R2) in the vertical direction (D3) by being etched;
forming a word line opening (OP1) to divide the preliminary channel pattern (176) into a plurality of channel patterns (CL);
replacing the sacrificial pattern (174) with an insulating pattern (111; 116);
forming a word line (WO) in the word line opening (OP1);
exposing the second region (R2) by removing the sacrificial channel pattern (177) and the dummy sacrificial pattern (175); and
forming a peripheral gate structure (PGA) on the second region (R2).

10. The method of claim 9, wherein removing the sacrificial channel pattern (177) and the dummy sacrificial pattern (175) includes:
forming a photoresist pattern (PR3); and
removing the sacrificial channel pattern (177) and the dummy sacrificial pattern (175) using the photoresist pattern (PR3) as an etching mask,
wherein the photoresist pattern (PR3) at least partially overlaps the first region (R1) in the vertical direction (D3) and does not overlap the second region (R2) in the vertical direction (D3).

11. The method of claim 9, wherein forming the word line opening (OP1) includes:
forming a photoresist pattern (PR2); and
forming the word line opening (OP1) using the photoresist pattern (PR2) as an etching mask,
wherein an entirety of the second region (R2) is overlapped by the photoresist pattern (PR2; PR3) in the vertical direction (D3).

12. The method of claim 9,
wherein etching the preliminary channel layer (172) and the sacrificial layer (171) includes:
forming a trench (TR) extending in the preliminary channel layer (172) and the sacrificial layer (171); and
forming an isolation structure (130) in the trench (TR),
wherein the isolation structure (130) is between the first region (R1) and the second region (R2).

13. The method of claim 12, further comprising:
forming a photoresist pattern (PR1); and
etching the isolation structure (130) using the photoresist pattern (PR1) as an etching mask,
wherein the photoresist pattern (PR1) overlaps an entirety of the second region (R2) in the vertical direction (D3).

14. The method of claim 12, wherein removing the sacrificial channel pattern (177) and the dummy sacrificial pattern (175) includes exposing a sidewall of the isolation structure (130).

15. The method of claim 9, further comprising:
forming a word line contact (126) in contact with the word line (WO);
forming a peripheral gate contact (154) in contact with the peripheral gate structure (PGA); and
simultaneously forming a first conductive line (182) in contact with the word line contact (126) and a second conductive line (183) in contact with the peripheral gate contact (154).
